# EUROPEAN PATENT APPLICATION

(11) **EP 4 723 386 A1**
(43) Date of publication of application: **08.04.2026**
(21) Application number: 24204845.2
(22) Date of filing: 04.10.2024
(51) Int. Cl.: H01R 12/75, H01R 12/73, H05K 1/18, H05K 1/00

(54) **ELECTRONIC ASSEMBLY FOR A VEHICLE COMPRISING A CONNECTOR AND AN ELECTRONIC SUPPORT**

(71) Applicant: Valeo Comfort and Driving Assistance, 94000 Créteil (FR)
(72) Inventor: GLEICH, Hubert, 94000 Créteil (FR); WISCHNEWSKI, Dirk, 94000 Créteil (FR)
(74) Representative: Delaval, Guillaume Laurent

(57) **Abstract**

The invention relates to an electronic assembly (1) for a vehicle (2) comprising :
- at least one connector (10) with at least one pin (100) and at least one opening (101) for passing said at least one pin (100) therethrough,
- an electronic support (11) comprising at least one hole (110) for passing said at least one connector (10) therethrough,
wherein :
- said at least one connector (10) is tilted compared to a plane (X-Y) along which said electronic support (11) extends, and is configured to pass through said electronic support (11) via said at least one hole (110),
- said at least one pin (100) comprises a first section (100.1) and a second section (100.2), said first section (100) being configured to pass through said at least one connector (10) via said opening (101) and being tilted with the same first angle (θ), said second section (100.2) being connected to said first section (100.1) and to said electronic support (11).

## Description

The present invention relates to an electronic assembly for a vehicle that comprises at least one connector and an electronic support. Such an electronic assembly may be used, but not exclusively, in the automotive domain.

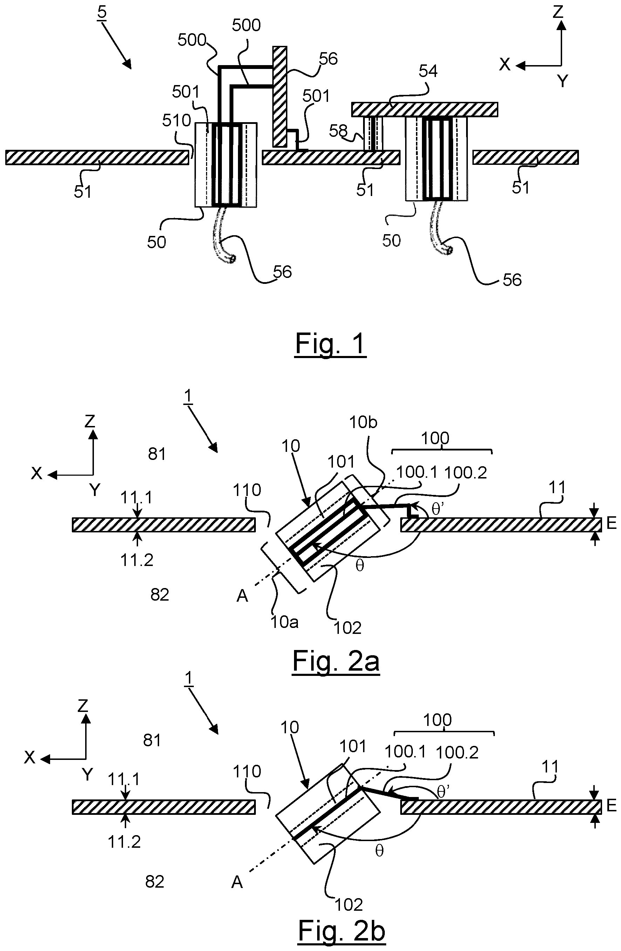

In the automotive domain, an electronic assembly 5 for a vehicle that comprises at least one connector 50 and an electronic support 51, well-known by the person skilled in the art, and illustrated in figure 1, is often used in a telematics control unit. The at least one connector 50 comprises at least one pin 500 and at least one opening 101 for passing said at least one pin 500 therethrough, and the electronic support 51 comprises at least one hole 510 for passing said at least one connector 50 therethrough. The at least one connector 50 is placed vertically compared to the electronic support 51.

The electronic support 51 is configured to receive electronic components of the telematic control unit such as the antennas (cellular antennas, or V2X antennas), radiofrequency modules etc..

In order to permit freedom for positioning the electronic support 51, the electronic assembly 5 of the prior art can comprise an additional electronic support 54 which is parallel to the electronic support 51 as illustrated in figure 1 and an additional connector 55 as illustrated in figure 1 to connect the additional electronic support 54 to the electronic support 51. It permits disconnecting the connector 50 from the electronic support 51 that can be placed at different position levels and give a new position level for the connector 50. Indeed, traditionally, the connector 50 is placed on the electronic support 51. Thus, it gives more space for some hardness cables 56 below the connector 50 to which they can be connected to. Hence, it gives more freedom for the global design of the electronic assembly 5.

In order to permit freedom for positioning the electronic support 51, another solution is for the electronic assembly 5 to comprise an additional connector 58 that is perpendicular to the electronic support 51 and that is connected :
- to the connector 50 via at least one right angle pin 500,
- to the electronic support 51 via an additional connection 501 like soldering, and

One problem of these solutions is that depending on where the telematics control unit is installed in the vehicle, there can be limitation of the volume of the housing of the telematics control unit that comprises the electronic assembly, in particular in height. The two solutions of the prior art are not able to reduce the height of the volume. On the contrary, due to the additional electronic support 54 or 56, the height is increased. Moreover, the cost of the electronic assembly is increased and so is the time manufacturing due to all these additional elements that needed to be assembled.

It is an object of the invention to provide an electronic assembly, which resolves at least one of the problems above-stated.

To this end, it is provided an electronic assembly for a vehicle comprising :
- at least one connector with at least one pin and at least one opening for passing said at least one pin therethrough,
- an electronic support comprising at least one hole for passing said at least one connector therethrough,
wherein :
- said at least one connector is tilted compared to a plane along which said electronic support extends, and is configured to pass through said electronic support via said at least one hole,
- said at least one pin comprises a first section and a second section, said first section being configured to pass through said at least one connector via said opening and being tilted with the same first angle, said second section being connected to said first section and to said electronic support.

As we will see in further details, thanks to the tilted position of the connector, one has lowered the height in a vertical direction taken by the electronic assembly, without additional elements needed. With the solution of the invention, one keeps the freedom of global design, as one can place the electronic support at different positioning levels. For example, if the electronic support needs to be positioned as low as possible (compared to a vertical direction) in a housing of the telematics control unit, for the purpose of antennas efficiency and/or of cooling efficiency of the electronic components, the tilted position of the connector permits to do so.

According to non-limitative embodiments of the invention, the electronic assembly in accordance with the invention further comprises the following characteristics.

In a non-limitative embodiment, the connector totally passes through the electronic support.

In a non-limitative embodiment, said at least one connector is tilted with a first angle that is greater than 90° compared to said plane, said first angle being defined as the angle between a central longitudinal axis of said at least one connector and a second face of said electronic support, said electronic support having a first face and said second face opposite from said first face.

In a non-limitative embodiment, said electronic assembly comprises a plurality of connectors.

In a non-limitative embodiment, said at least one connector comprises a plurality of pins.

In a non-limitative embodiment, said first section is configured to be connected to at least one hardness cable.

In a non-limitative embodiment, said at least one connector is a dual/multi line connector, or a single line connector or a coax connector.

In a non-limitative embodiment, said at least one connector is a dual/multi line connector.

In a non-limitative embodiment, the electronic support has a first face and a second face opposite from the first face.

In a non-limitative embodiment, the electronic support delimits one first area on the side of its first face and one second area on the side of its second face, and one extremity of the connector is found in the first area delimited by the electronic support and the other extremity is found in the second area delimited by the electronic support.

In a non-limitative embodiment, the other extremity is found in the second area and is partly buried in the thickness of the electronic support.

It is also provided a telematics control unit comprising an electronic assembly according to any of the preceding characteristics.

Some embodiments of methods and/or apparatus in accordance with embodiments of the present invention are now described, by way of example only, and with reference to the accompanying drawings, in which:

[Fig. 1] illustrates a schematic figure of a side view of an electronic assembly for a vehicle according to the prior art,

[Fig. 2a] illustrates a schematic figure of a side view of an electronic assembly for a vehicle according to a first non-limitative embodiment of the invention, said electronic assembly comprising an electronic support and at least one connector according to a first non-limitative variant of embodiment,

[Fig. 2b] illustrates a schematic figure of a side view of an electronic assembly for a vehicle according to a first non-limitative embodiment of the invention, said electronic assembly comprising an electronic support and at least one connector according to a second non-limitative variant of embodiment,

[Fig. 2c] is a schematic figure of a side view of an electronic assembly for a vehicle according to a first non-limitative embodiment of the invention, said electronic assembly comprising an electronic support and at least one connector according to a first embodiment of a third non-limitative variant of embodiment,

[Fig. 3] is a schematic figure of a side view of an electronic assembly for a vehicle according to a second non-limitative embodiment of the invention, said electronic assembly comprising an electronic support and two connectors,

[Fig. 4] is a schematic figure of a telematics control unit for a vehicle that comprises an electronic assembly according to figure 2b.

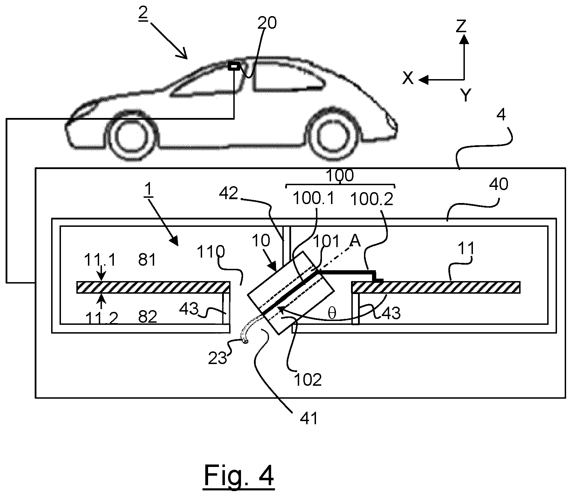

The present invention relates to an electronic assembly 1 for a vehicle 2, said electronic assembly 1 being described in reference to figures 1a to 4, according to non-limitative embodiments. In a non-limitative embodiment, said vehicle 2 (illustrated in figure 4) is an automobile vehicle. In non-limitative examples, said automobile vehicle is a combustion-engine vehicle, an electrical vehicle or a hybrid vehicle.

In a non-limitative embodiment, the electronic assembly 1 is part of a telematics control unit 4 referred to as TCU in the following and illustrated in figure 4.

The TCU permits wireless communication of the vehicle with cloud services, other vehicles, base stations etc. to exchange information such as in non-limitative examples the position of the vehicle, the speed of the vehicle, engine data etc. In non-limitative examples, the TCU is used for the safety of the driver and passengers, to optimize the traffic flow and to make automatic emergency calls when an accident occurs.

As illustrated in figure 4, the TCU comprises a housing 40 that is configured to receive the electronic assembly 1.

In a non-limitative embodiment, the TCU is independent from the body of the vehicle 2 and is fixed to a structure 20 of the body of the vehicle 2. In a non-limitative embodiment, the structure 20 is part of the roof of the vehicle 2. In this case, in a non-limitative example the structure 20 is a decorative part of the roof and the TCU is fixed inside the vehicle on this decorative part.

As illustrated in figures 2a to 4, the electronic assembly 1 comprises :
- at least one connector 10 with at least one pin 100,
- an electronic support 11.

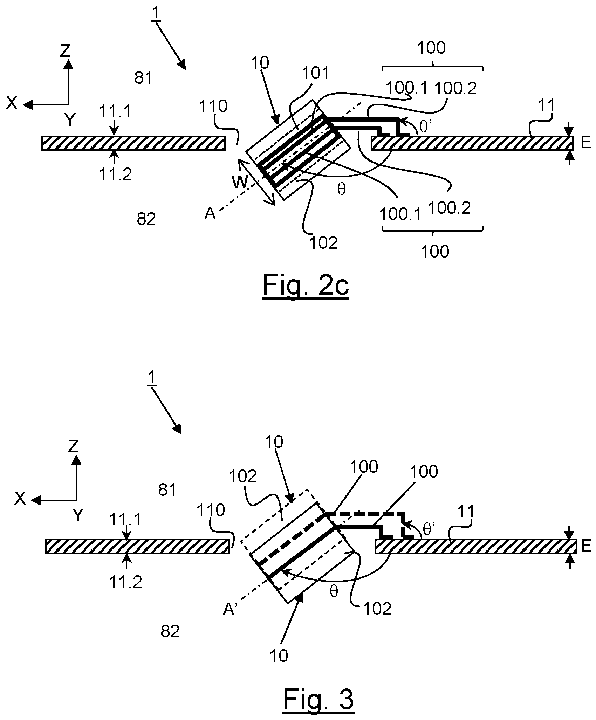

In a non-limitative embodiment illustrated in figure 2a to 2c, the electronic assembly 1 comprises one connector 10. In another non-limitative embodiment illustrated in figure 3, it comprises a plurality of connectors.

In a non-limitative embodiment illustrated in figures 2a, 2b and 3, the connector 10 comprises only one pin 100. In another non-limitative embodiment illustrated in figure 2c, the connector 10 comprises a plurality of pins 100.

The electronic support 11 extends along a plane X-Y. In particular, in a non-limitative example, it extends :
- in length along a first direction X, and
- in width along a second direction Y. The width can be equal to the length or is different from the length.

This first direction X and this second direction Y are perpendicular to a third direction Z called vertical direction in the following. The electronic support 11 has a thickness E in the vertical direction Z.

In a non-limitative embodiment, the electronic support 11 is a printed circuit board assembly referred to as PCBA in the following.

The electronic support 11 has a first face 11.1 and a second face 11.2 which is opposite to the first face 11.1. In a non-limitative embodiment, the first face 11.1 is turned towards the structure 20 of the vehicle 2 when the TCU that comprises the electronic assembly 1 is installed in the vehicle 2. The electronic support 11 delimits two areas illustrated in figures 2a to 4 : one first area 81 on the side of the first face 11.1 and one second area 82 on the side of the second face 11.2.

The electronic support 11 comprises one hole 110 for passing the connector 10 therethrough. Hence, the connector 10 "dives" into the electronic support 11. If there are a plurality of connectors 10, in one non-limitative embodiment, the electronic support 11 comprises one hole 110 for passing only one connector 10 therethrough, or in another one non-limitative embodiment, one hole 110 can be used for passing the plurality of connectors 10 therethrough.

The connector 10 extends along a central longitudinal axis A.

The connector 10 comprises at least one opening 101 for passing at least one pin 100 therethrough, in particular a part of it. The connector 10 comprises a body 102 where the opening 101 is performed.

The connector 10 is configured to pass through the electronic support 11 via the hole 110.

The connector 10 is tilted compared to the plane X-Y along which the electronic support 10 extends. Thus, instead of being perpendicular to the electronic support 11, it is tilted so that is doesn't take a lot of space in height. Thus, one can reduce the height of the housing of the TCU that comprises the electronic assembly 1.

The connector 10 totally passes through the hole 110. By "totally", one means that one extremity 10a (illustrated in figure 2a) of the connector 10 is found in the first area 81 delimited by the electronic support 11 while the other extremity 10b (illustrated in figure 2a) is found in the second area 82 delimited by the electronic support 11. Hence, the two extremities 10a, 10b can't be found in the same area 81 or 82 delimited by the electronic support 11. As illustrated in figure 2a, in a non-limitative embodiment, the other extremity 10b is found in the second area 82 and is partly buried in the thickness E of the electronic support 11. It is to be noted that the references 10a and 10b have been illustrated only in figure 2a in order to not overload the other figures.

In a non-limitative embodiment, the connector 10 is tilted with a first angle θ that is greater than 90°. The first angle θ is the angle between the central longitudinal axis A of the connector 10 and the second face 11.2 of the electronic support 11.

As illustrated in figures 2a to 4, the pin 100 of the connector 10 comprises :
- a first section 100.1, and
- a second section 100.2.

The first section 100.1 is configured to pass through the connector 10 via the opening 101 described before. The first section 100.1 is tilted with the same first angle θ as the one connector 10 in order to be able to adjust to said opening 101.

In a non-limitative embodiment, the first section 100.1 is configured to be connected to at least one hardness cable 23 of the vehicle 2. It serves as an interface to connect said at least one hardness cable 23. The hardness cable ensures power supply to the electronic assembly 1, connects the electronic assembly 1 to an electronic control system(s) of the vehicle 2, like infotaintment systems.

The second section 100.2 is linked to the first section 100.1 and is connected to the electronic support 11. The second section 100.2 is therefore a connection tab to the electronic support 11. In a non-limitative embodiment, it is welded or soldered to said electronic support 11.

In a non-limitative embodiment, the second section 100.2 is connected to the electronic support 10 with a right second angle θ' (as illustrated in figure 2a and figure 2b), or with a "sloping" second angle θ' (as illustrated in figure 2c). By "sloping", one means that it is not a right angle. A right angle is easier to connect to the electronic support 11 and can left more space on the electronic support 51 than a sloping angle. The second angle θ' is defined as the angle between the first face 11.1 of the electronic support 11 and the second section 100.2 of the pin 100.

In a first non-limitative embodiment illustrated in figures 2a to 2c, the electronic assembly 1 comprises one connector 10.

As illustrated in figure 2a, in a first non-limitative variant of the first embodiment, the connector 10 is a coax connector. In a non-limitative example, the coax connector is used for radiofrequency signals.

As illustrated in figure 2b, in a second non-limitative variant of the first embodiment, the connector 10 is a single line connector. It means that there are many pins along one line. It is to be noted that only one pin has been illustrated in figure 2b. In a non-limitative example, the single line connector is used for power supply.

As illustrated in figure 2c, in a third non-limitative variant of the first embodiment, the connector 10 is a dual/multi connector. It means that there are many pins along many lines. In a non-limitative example, the dual/multi connector is used for power supply and digital signals.

In a second non-limitative embodiment illustrated in figure 3, the electronic assembly 1 comprises a plurality of connectors 10. In the non-limitative example illustrated in figure 3, it comprises two connectors 10. To simplify the figure, the first section 100.1 and the second section 100.2 of each pin 100 have not been referenced with their numbers. In order to clarify the figure, the second connector 10 has been illustrated in dashes. In non-limitative embodiments, the plurality of connectors 10 can be coax connectors, single line connectors or dual/multi connectors. One can have different combinations of these embodiments.

As illustrated in figure 4, the electronic assembly 1 is placed inside the housing 40 of the TCU.

The housing 40 comprises at least one opening 41 for the connector 10 of the electronic assembly 1 to pass through. The opening 41 is used also for passing the hardness cable 23 through. There is one opening 41 for each connector 10 of the electronic assembly 1 or there is one opening 41 for a plurality of connectors 10.

The housing 40 comprises walls 43 that extends until the electronic support 11 of the electronic assembly 1 for closing the housing 40.

In a non-limitative embodiment, there is at least one holder 42 that is configured to hold said at least one connector 10 to the housing 40 of the TCU. In a non-limitative variant of embodiment, the holder 42 is part of the housing 40 as illustrated in figure 4. In non-limitative examples, it is a pin or a dome. In another non-limitative variant of embodiment not illustrated, the holder 42 is part of the connector 10.

It is to be understood that the present invention is not limited to the aforementioned applications. It is to be understood that the present invention is not limited to the aforementioned embodiments and variations and modifications may be made without departing from the scope of the invention. In this respect, the following remarks are made. All statements herein reciting principles, aspects, and embodiments of the invention, as well as specific examples thereof, are intended to encompass equivalents thereof. Hence, in other non-limitative embodiments, the structure 20 is the hood, the trunk or the tailgate of the vehicle 2. Hence, in other non-limitative embodiments, another application where the electronic assembly 1 of the invention can be used is the application of housing appliances or machineries.

Hence, some embodiments of the invention may comprise one or a plurality of the following advantages:
- it is a better solution than the prior art that consists in adding some new material such as additional electronic supports and additional connectors,
- it permits to reduce the cost and the time manufacturing of the electronic assembly 1 while resolving the problem of restriction of the volume available in the housing 40 of the TCU for the electronic assembly 1, in particular in height,
- it permits at the same time to keep the freedom to arrange the electronic support 11 at different positioning levels, in particular at a low level if necessary, and hence to have a good freedom in the global design of the electronic assembly 1.

## Claims

1. Electronic assembly (1) for a vehicle (2) comprising :
- at least one connector (10) with at least one pin (100) and at least one opening (101) for passing said at least one pin (100) therethrough,
- an electronic support (11) comprising at least one hole (110) for passing said at least one connector (10) therethrough,
wherein :
- said at least one connector (10) is tilted compared to a plane (X-Y) along which said electronic support (11) extends, and is configured to pass through said electronic support (11) via said at least one hole (110),
- said at least one pin (100) comprises a first section (100.1) and a second section (100.2), said first section (100) being configured to pass through said at least one connector (10) via said opening (101) and being tilted with the same first angle (θ), said second section (100.2) being connected to said first section (100.1) and to said electronic support (11).

2. Electronic assembly (1) according to claim 1, wherein said at least one connector (10) is tilted with a first angle (θ) that is greater than 90° compared to said plane (X-Y), said first angle (θ) being defined as the angle between a central longitudinal axis (A) of said at least one connector (10) and a second face (11.2) of said electronic support (11), said electronic support (11) having a first face (11.1) and said second face (11.2) opposite from said first face (11.1).

3. Electronic assembly (1) according to any of the preceding claims, wherein said electronic assembly (1) comprises a plurality of connectors (10).

4. Electronic assembly (1) according to any of the preceding claims, wherein said at least one connector (10) comprises a plurality of pins (100).

5. Electronic assembly (1) according to any of the preceding claims, wherein said second section (100.2) is connected to said electronic support (11) with a right second angle (θ') or with a sloping second angle (θ').

6. Electronic assembly (1) according to any of the preceding claims, wherein said first section (100.1) is configured to be connected to at least one hardness cable (23).

7. Electronic assembly (1) according to any of the preceding claims, wherein said at least one connector (10) is a dual/multi line connector, or a single line connector or a coax connector.

8. Electronic assembly (1) according to the preceding claim, wherein said at least one connector (10) is a dual/multi line connector.

9. A telematics control unit (4) comprising an electronic assembly (1) according to any of the preceding claims.
